(19) **Europäisches Patentamt / European Patent Office / Office européen des brevets**

(11) **EP 3 102 018 B1**

(12) **EUROPEAN PATENT SPECIFICATION**

(45) Date of publication and mention of the grant of the patent:
**18.09.2019 Bulletin 2019/38**

(51) Int Cl.:
*H05K 13/08* (2006.01)       *B23K 1/00* (2006.01)
*G05B 19/418* (2006.01)       *B23K 101/42* (2006.01)

(21) Application number: **15743608.0**

(22) Date of filing: **27.01.2015**

(86) International application number:
**PCT/JP2015/052212**

(87) International publication number:
**WO 2015/115432 (06.08.2015 Gazette 2015/31)**

(54) **QUALITY MANAGEMENT DEVICE AND METHOD FOR CONTROLLING QUALITY MANAGEMENT DEVICE**

QUALITÄTSVERWALTUNGSVORRICHTUNG UND VERFAHREN ZUR STEUERUNG DER QUALITÄTSVERWALTUNGSVORRICHTUNG

DISPOSITIF DE MANAGEMENT DE LA QUALITÉ ET PROCÉDÉ DE COMMANDE D'UN DISPOSITIF DE MANAGEMENT DE LA QUALITÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.01.2014 JP 2014014468**

(43) Date of publication of application:
**07.12.2016 Bulletin 2016/49**

(73) Proprietor: **Omron Corporation Kyoto-shi, Kyoto 600-8530 (JP)**

(72) Inventors:
• **MORI, Hiroyuki**
  **Kyoto-shi**
  **Kyoto 600-8530 (JP)**
• **FUJII, Shimpei**
  **Kyoto-shi**
  **Kyoto 600-8530 (JP)**
• **TANAKA, Mayuko**
  **Kyoto-shi**
  **Kyoto 600-8530 (JP)**
• **KAWAI, Naohiro**
  **Kyoto-shi**
  **Kyoto 600-8530 (JP)**
• **OGURA, Yoshiharu**
  **Kyoto-shi**
  **Kyoto 600-8530 (JP)**

(74) Representative: **Kilian Kilian & Partner Aidenbachstraße 54 81379 München (DE)**

(56) References cited:
**JP-A- H11 298 200      JP-A- 2006 216 589**
**JP-A- 2009 116 842      US-A- 5 560 533**

**Description**

TECHNICAL FIELD

The present invention relates to a quality management apparatus in a printed circuit board production line.

BACKGROUND ART

Surface mounting is one of method for mounting a component on a printed circuit board. In the surface mounting, solder paste is applied onto the printed circuit board, and solder is heated and melted after the component to be mounted is placed on the solder, thereby fixing the component. Because a highly-integrated board can be produced, the surface mounting is frequently adopted in an apparatus that automatically mounts the component on the printed circuit board.

In the case that the component is automatically mounted on the board, it is necessary to inspect whether the component is normally mounted on the board after the solder is cooled. Particularly, from the viewpoint of a guarantee of product quality, it is necessary to correctly determine whether a connection portion of terminal included in the component and an electrode (land) on the board is normally soldered.

In the case that a defect occurs in a bonding state of the component, it is necessary to identify a factor causing the defect. This is because possibly a similar defect occurs consecutively unless the factor causing the defect in a preceding process is removed. For example, in a quality analysis method described in Patent Document 1, when mounting quality of an electronic component is inspected to detect the defect, whether the defect is caused by the mounting of the component in which the defect occurs or the mounting of an adjacent component is estimated to generate a countermeasure instruction to a production facility.

Further prior art documents are US 5 560 533 A, JP 2006 216589 A, and JP 2009 116842 A. US 5 560 533 A discloses a mounted circuit board producing system includes a plurality of mounted circuit board production lines having a solder printing unit, a component mounting unit, and a soldering unit. The system includes an inspection device for inspecting at least one equipment at the solder printing unit, component mounting unit, and soldering unit and given monitor items with respect to circuit boards to be mounted, a data analyzing part for analyzing, according to a warning criterion applicable prior to a predetermined defective judgement criterion being reached, qualitative conditions of both the equipment and individual circuit boards from results of inspections made by the inspection device, and a control device for controlling, on the basis of analysis results at the data analyzing part, at least one of the solder printing unit, component mounting unit, and soldering unit for a change of operating conditions over the entire production line; JP 2006 216589 A discloses an imaging means picks up images of a printed board in each process in a series of processes for soldering components on the printed board. An image storage means stores (accumulates) the picked-up images in each of processes so that they may be correlated. An inspection means inspects the solder mounting quality from the picked-up image of the final process. Then, if a failure is detected by inspection, a candidate event selecting means selects one or more events which may be a cause of the failure among the events which may be generated in designing steps or an intermediate processes in manufacturing. An event analyzing means determines the degree of occurrence of each of candidate events by referring to the picked-up images in the intermediate processes.; A cause analyzing means estimates the cause of the failure on the basis of combinations of the degree of occurrence of each of the candidate events and JP 2009 116842 A discloses a factor estimating support device supports estimation of factors from a result generated in a production system. In the factor estimating support device, material/environment history data and test history data obtained from the production system and causality structure data indicating causality among the plurality of variables are stored in the storage part, where when determined that the final quality characteristic is abnormal by a final quality abnormal detecting part, determination is made on whether each variable other than the final quality characteristic is abnormal in a variable abnormality detecting part, and the result of determination is reflected on a visible image in which the causality structure data are made visible in a visible image creating part.

PRIOR ART DOCUMENT

PATENT DOCUMENT

Patent Document 1: Japanese Patent No. 4020900

SUMMARY OF THE INVENTION

PROBLEMS TO BE SOLVED BY THE INVENTION

According to the method of Patent Document 1, in the case that the defect is caused by interference of the adjacent component, the factor causing the defect can be identified.

However, various factors cause the final mounting defect of the component. For example, in a solder printing process, a solder amount or a printing misregistration can cause the defect. In a component mounting process, a pushing amount or mounting misregistration of the component can cause the defect. In the method of Patent Document 1, although whether the defect is caused by the interference of the component can be estimated, which one of parameters causes the defect in the preceding process can hardly be narrowed down with accuracy.

On the other hand, it is also conceivable that the inspection is performed to remove a defective every time such a process as the solder printing process and the component mounting process is ended. However, in the inspection performed at the end of each process, although the factor (for example, a missing component or a polarity error) that clearly causes the defect can be detected, whether the product becomes finally defective can hardly be decided until the solder bonding is actually performed in the case that the misregistration or the like occurs slightly.

That is, in the surface mounting line, whether the board is the nondefective or defective is hardly determined with accuracy until the solder bonding is performed, and it is difficult to identify which one of the processes the factor exists in when the defect is detected after a completion state.

An object of the present invention is to provide a technology of accurately identifying the factor in the case that quality deterioration is detected in the surface mounting line. This object is achieved by the subject-matter of the independent claims. Further advantageous embodiments are the subject-matter of the dependent claims. Aspects of the invention are set out below.

A quality management apparatus according to one aspect of the present invention is an apparatus that manages quality of a printed circuit board produced in a surface mounting line including a solder printing apparatus configured to print solder on the printed circuit board, a mounter configured to dispose an electronic component on the printed circuit board, a first inspection apparatus configured to inspect a solder printing state and an electronic component disposition state, a reflow furnace configured to solder the electronic component, and a second inspection apparatus configured to inspect a bonding state of the electronic component and the printed circuit board.

Specifically, the quality management apparatus includes: a defective factor estimator configured to extract, when the second inspection apparatus detects a defect, an inspection item that is estimated to be associated with the defect in inspection items inspected with the first inspection apparatus; a quality determination unit configured to acquire an inspection result corresponding to the extracted inspection item from the first inspection apparatus, and to determine whether the inspection result indicates an abnormality; and a parameter changer configured to decide a parameter to be changed and a content of the parameter in parameters used in the solder printing apparatus or the mounter when the inspection result indicates the abnormality.

The second inspection apparatus is an apparatus that inspects the solder bonding state. At this point, when a bonding defect is detected, it is considered that the defect is caused in the printing process of applying the solder onto the printed circuit board or the mounting process of disposing the electronic component on the printed circuit board.

In the quality management apparatus of the present invention, when the second inspection apparatus detects some sort of defect, the defective factor estimator extracts the inspection item that is likely to be associated with the defect in the inspection items inspected with the first inspection apparatus. For example, when a component height is larger than a specified value, the inspection item for the component mounting position is extracted because a causal factor is considered to be a deviation of the component mounting position. When an electrode exposure amount is larger than a specified value, the inspection item for the solder printing position is extracted because the causal factor is considered to be a deviation of the solder printing position.

The quality determination unit acquires the inspection result (that is, the inspection results associated with the solder printing and the component mounting) corresponding to the extracted inspection item from the first inspection apparatus, and determines whether the abnormality is recognized in the inspection result.

For example, the term "the abnormality is recognized in the inspection result" means the case that the measured value is inclined toward a value except for a normal value or the case that the measured value varies excessively. In this case, the parameter changer identifies the mounting parameter (for example, the solder printing position or the component mounting position) associated with the inspection item, and decides the post-change content.

Whether the deviation or variation of the measured value influences the final quality can hardly be determined in the inspection after the end of each process. On the other hand, in the quality management apparatus of the present invention, the factor influencing the quality can be identified by checking the measured value of the corresponding place in the preceding process when the mounting defect occurs. The change content of the mounting parameter is automatically decided, so that the state in which the defect does not occur can be recovered in a short time even if the defect occurs temporarily.

The quality determination unit may acquire a measured value distribution in the estimated inspection item, and make the determination that the inspection result indicates the abnormality when a measured value is distributed while exceeding an abnormal determination criterion.

For example, the term "the measured value is distributed while exceeding the abnormal determination criterion" means the case that the measured values exceed the upper and lower limits, the case that a ratio of the measured value exceeding the upper and lower limits is larger than a predetermined value, or the case that the process capability index is lower than a default. In such cases, because the quality varies, it can be determined that the detected defect is caused by the variation.

When one of an excessive amount on an upper limit side of the abnormal determination criterion and an excessive amount on a lower limit side is larger than the other in the acquired measured value distribution, the parameter changer may decide the parameter to be changed and the content of the parameter such that the measured value distribution is moved in a direction in which ununiformity of the excessive amount is solved.

In the measured value distribution, the case that one of the excessive amount on the upper limit side of the abnormal determination criterion and the excessive amount on the lower limit side is larger than the other means that the measured value is inclined toward the up and down direction. In such cases, the mounting parameter to be changed and the change content may be decided such that measured value distribution is moved in the direction in which the ununiformity of the excessive amount is solved.

The quality determination unit may calculate a process capability index in a predetermined collecting unit from the inspection result acquired from the first inspection apparatus, and may set the abnormal determination criterion based on the process capability index when a defective product is included in the collecting unit.

The collecting unit means a unit in which the products are divided in each predetermined value such as a lot, a given time, and a given number of boards. When the defective is included in the collecting unit, the abnormal determination criterion can be decided on the basis of the process capability index in the collecting unit. This is because the occurrence of the defective is predicted when the board is produced with an index below the calculated process capability index.

The quality determination unit may periodically acquire the inspection result from the first inspection apparatus to update the abnormal determination criterion.

Because a process capability is not always kept constant in the production process, preferably the abnormal determination criterion is periodically updated on the basis of the measured value.

The parameter changer may apply the decided parameter to be changed to the solder printing apparatus or the mounter.

The quality management apparatus according to the present invention may further include an output unit configured to output information to a user. At this point, the parameter changer may output the decided parameter to be changed through the output unit.

The changed parameter may be applied to the solder printing apparatus or the mounter without any condition, or the changed parameter may temporarily be output such that a user can check the changed parameter. Even if an operator who has a specific skill is absent, the quality can be recovered by automatically applying the changed parameter. Additionally, the output of the information facilitates the user recognition of the line state.

The output unit may be a display apparatus, and the parameter changer may output at least one of a content of the defect detected with the second inspection apparatus, the inspection item estimated to be associated with the defect, whether the inspection result corresponding to the inspection item indicates the abnormality, and the parameter to be changed and the content of the parameter through the output unit when the parameter to be changed is decided.

In presenting the information to the user, preferably the parameter to be changed is presented together with a reason why the parameter is changed. Therefore, the user can judge whether the change of the parameter is adequate.

The quality management apparatus may further include an association degree calculator configured to obtain an association degree between inspection items by comparing the inspection result of the second inspection apparatus to the inspection result of the first inspection apparatus. At this point, the defective factor estimator extracts the inspection item estimated to be associated with the detected defect based on the association degree between the inspection items.

The association degree calculator calculates the association degree between the inspection items in different processes. Specifically, the inspection item associated with the solder bonding state and the inspection item associated with the solder printing or component mounting are compared to each other, and the association degree between the inspection items is numerically calculated. For example, the association degree can be obtained by a correlation between the measured values. The defective factor estimator associates the detected defect with the inspection item in the preceding process on the basis of the calculated association degree. The inspection item associated with the causal factor is associated on the basis of the measured value, so that the causal factor can be identified with higher accuracy.

The present invention can be comprehended as a quality management apparatus including at least a part of the units. The present invention can be comprehended as a method for controlling the quality management apparatus, a program that operates the quality management apparatus, and a recording medium in which the program is recorded.

As long as the technical inconsistency is not generated, the pieces of processing or the units can be implemented while freely combined.

EFFECT OF THE INVENTION

Accordingly, in the present invention, when the quality deterioration is detected in the surface mounting line, the factor of the quality deterioration can be identified with high accuracy.

BRIEF DESCRIPTION OF THE DRAWINGS

Fig. 1 is a view illustrating a production and inspection flow of a board through a surface mounting system.
Fig. 2 is a view illustrating a data flow in a first embodiment.
Fig. 3 is a view illustrating an example of inspection result information in the first embodiment.
Fig. 4 is a view illustrating a causal relationship between a mounting parameter and an inspection item.
Fig. 5 is a view illustrating an example of an inspection-item-associated table in the first embodiment.
Fig. 6 is a view illustrating an abnormal determination based on a measured value distribution.
Fig. 7 is a view illustrating an example of a correction parameter table in the first embodiment.
Fig. 8 is a flowchart illustrating operation of an analyzer of the first embodiment.
Fig. 9 is a flowchart illustrating a processing of generating the inspection-item-associated table.
Fig. 10 is a view illustrating a correlation between inspection items in a third embodiment.
Fig. 11 is a second view illustrating the correlation between the inspection items in the third embodiment.

MODES FOR CARRYING OUT THE INVENTION

(System configuration)

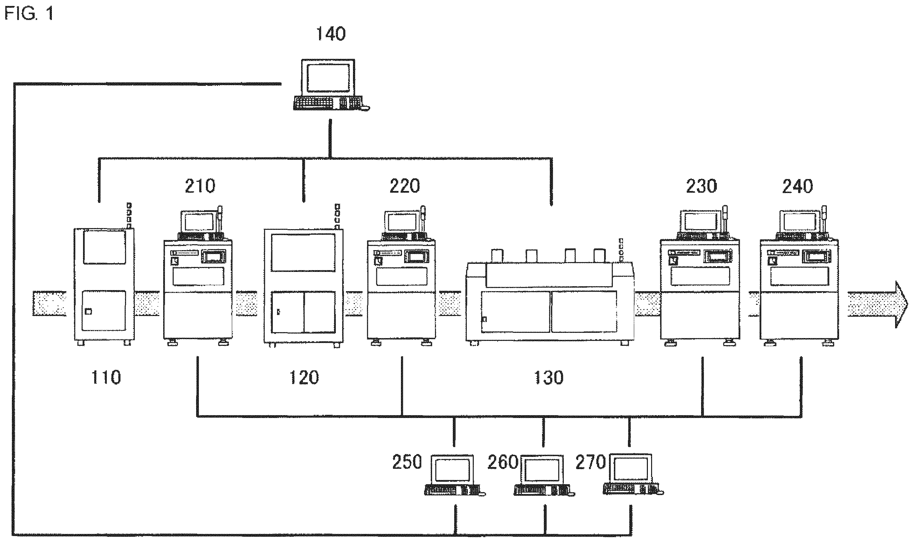

Fig. 1 is a view schematically illustrating configuration example of production facilities and a quality control system in a surface mounting line of a printed circuit board. A Surface Mount Technology (SMT) is a technology of soldering the electronic component on the surface of the printed circuit board, and the surface mounting line is mainly constructed with three processes, namely, solder printing, component mount, and reflow (welding of solder).

As illustrated in Fig. 1, in the surface mounting line, a solder printing apparatus 110, a mounter 120, and a reflow furnace 130 are sequentially provided from an upstream side as the production facilities. The solder printing apparatus 110 is an apparatus that prints the solder paste onto an electrode portion (called a land) on a printed circuit board by the screen printing. The mounter 120 is an apparatus that picks up the electronic component to be mounted on the board and places the component on the solder paste at the corresponding point, and the mounter 120 is also called a chip mounter. The reflow furnace 130 is a heating apparatus that heats and melts the solder paste, and cools the solder paste to bond the electronic component onto the board. The production facilities 110 to 130 are connected to a production facility management apparatus 140 through a network (LAN). The production facility management apparatus 140 is a system that manages and wholly controls the production facilities 110 to 130. The production facility management apparatus 140 includes functions of storing, managing, and outputting a mounting program (including an operation procedure, a production condition, and a setting parameter) defining an operation of each production facility and log data of each production facility. The production facility management apparatus 140 also includes a function of updating the mounting program set to the corresponding production facility when an instruction to change the mounting program is received from an operator or another apparatus.

A quality control system is installed in the surface mounting line. The quality control system inspects a state of the board at an exit of each of the processes of the solder printing, the component mount, and the reflow, and automatically detects the defect or a risk of the defect. In addition to a function of automatically sorting the nondefective and defective, the quality control system has a function (for example, the change of the mounting program) of performing feedback to the operation of each production facility on the basis of the inspection result or an analysis result of the inspection result.

As illustrated in Fig. 1, the quality control system according to an exemplary embodiment includes four kinds of inspection apparatuses, an inspection management apparatus 250, an analyzer 260, and a workstation 270. The four kinds of inspection apparatuses include a solder printing inspection apparatus 210, a component inspection apparatus 220, an appearance inspection apparatus 230, and an X-ray inspection apparatus 240.

The solder printing inspection apparatus 210 is an apparatus that inspects the state of the solder paste printed on the board carried out from the solder printing apparatus 110. In the solder printing inspection apparatus 210, the solder paste printed on the board is two-dimensionally or three-dimensionally measured, whether each kind of an inspection item is a normal value (permissible range) is determined from a measurement result. Examples of the inspection items include a volume, an area, a height, misregistration, and a shape of the solder. An image sensor (camera) can be used in the two-dimensional measurement of the solder paste, and a laser displacement meter, a phase shift method, a spatial coding method, and a photo cutting method can be adopted in the three-dimensional measurement.

The component inspection apparatus 220 is an apparatus that inspects a disposition state of the electronic component with respect to the board carried out from the mounter 120. In the component inspection apparatus 220, the component (component body or such a part of the component as an electrode (lead)) placed on the solder paste is two-dimensionally or three-dimensionally measured, whether each kind of the inspection item is the normal value (permissible range) is determined from the measurement result. Examples of the inspection items include the misregistration and angle (rotation) deviation of the component, shortage (the component is not disposed), a wrong component (a wrong component is disposed), wrong polarity (the component side and the board side differ from each other in an electrode polarity), reversal (the component is reversely disposed), and a component height. Similarly to the solder printing inspection, the image sensor (camera) can be used in the two-dimensional measurement of the electronic component, and the laser displacement meter, the phase shift method, the spatial coding method, and the photo cutting method can be adopted in the three-dimensional measurement.

The appearance inspection apparatus 230 is an apparatus that inspects a soldering state of the board carried out from the reflow furnace 130. In the appearance inspection apparatus 230, the post-reflow soldered portion is two-dimensionally or three-dimensionally measured, whether each kind of the inspection item is a normal value (permissible range) is determined from a measurement result. In addition to the same inspection items as the component inspection, the nondefective of defective of a solder fillet shape is also included in the inspection item. What is called a color highlight method (a soldering surface is irradiated with R, G, and B illuminations at different incident angles, and reflected light of each color is photographed with a zenith camera, whereby the three-dimensional shape of the solder is detected as two-dimensional hue information) can be adopted as the measurement of the solder shape in addition to the laser displacement meter, the phase shift method, the spatial coding method, and the photo cutting method.

The X-ray inspection apparatus 240 is an apparatus (quality management apparatus) that inspects the soldered state of the board using an X-ray image. For a package component such as a BGA (Ball Grid Array) and a CSP (Chip Size Package) or a multilayer board, because the solder bonding portion is hidden behind the component or board, the appearance inspection apparatus 230 can hardly inspect the soldered state (that is, the soldered state is hardly inspected in the appearance image). The X-ray inspection apparatus 240 is an apparatus that complements a weak point of the appearance inspection. Examples of the inspection items of the X-ray inspection apparatus 240 include the misregistration of the component, the solder height, the solder volume, a diameter of a solder ball, the back fillet length, and the nondefective and defective of the solder bonding. An X-ray transmission image may be adopted as the X-ray image, or preferably a CT (Computed Tomography) image is also used.

The inspection apparatuses 210 to 240 are connected to the inspection management apparatus 250 through the network (LAN). The inspection management apparatus 250 is a system that manages and wholly controls the inspection apparatuses 210 to 240. The inspection management apparatus 250 includes functions of storing, managing, and outputting an inspection program (including an operation procedure, an inspection condition, and a setting parameter) defining operations of the inspection apparatuses 210 to 240 and the inspection results or pieces of log data obtained with the inspection apparatuses 210 to 240.

The analyzer 260 is a system that includes a function of performing prediction or factor estimation of the defect by analyzing the inspection results (the inspection results of the processes) of the inspection apparatuses 210 to 240, the inspection results of the inspection apparatuses 210 to 240 being aggregated into the inspection management apparatus 250, and a function of performing the feedback (such as the change of the mounting program) to each of the production facilities 110 to 130 as needed basis.

The workstation 270 is a system that includes a function of displaying pieces of information about the states of the production facilities 110 to 130, the inspection results of the inspection apparatuses 210 to 240, and the analysis result of the analyzer 260, a function of changing (editing) the mounting program and inspection program of the production facility management apparatus 140 and inspection management apparatus 250, and a function of checking an operating situation of the whole surface mounting line.

Each of the production facility management apparatus 140, the inspection management apparatus 250, and the analyzer 260 can be constructed with a general-purpose computer system including a CPU (Central Processing Unit), a main storage device (memory), an auxiliary storage device (such as a hard disk), an input device (such as a keyboard, a mouse, a controller, and a touch panel), and a display. The apparatuses 140, 250, and 260 can be separately be provided, all the functions of the apparatuses 140, 250, and 260 can be implemented in one computer system, or a part of or all the functions of the apparatuses 140, 250, and 260 can be implemented in a computer included in one of the production facilities 110 to 130 and the inspection apparatuses 210 to 240. Although the networks of the production facilities and quality control system are individually illustrated in Fig. 1, a network having any configuration can be used as long as data communication can be conducted between the production facilities and the quality control system.

(First embodiment)

A quality management system according to a first embodiment in the surface mounting line will be described below.

The quality management system is a system in which, on the basis of the inspection results output from the inspection apparatuses 210 to 240, the factor causing the quality deterioration occurring in the product is identified to automatically feed back a proper mounting parameter to the production facility. As used herein, the mounting parameter means a parameter that is used in the solder printing or the component mounting. For example, the mounting parameter is a value defining an offset during the disposition of the component or a solder application pressure.

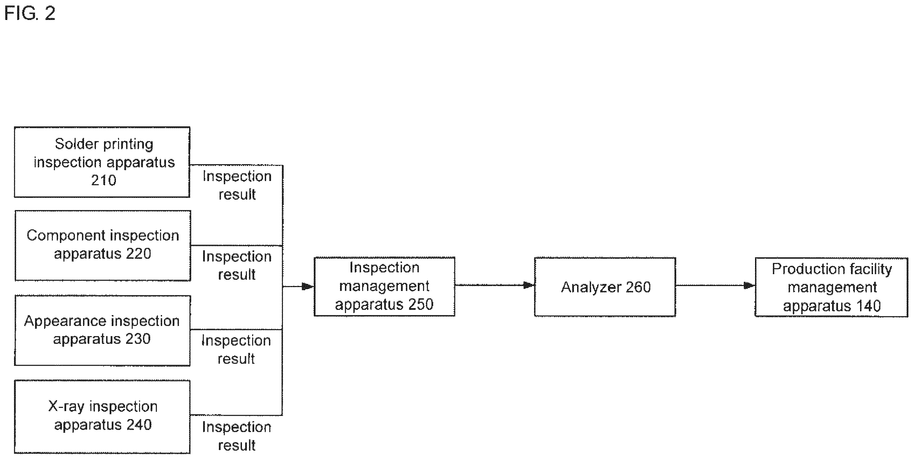

A data flow will be described with reference to Fig. 2. As described above, the solder printing inspection apparatus 210 is an apparatus that inspects whether the solder is normally printed on the board, and the component inspection apparatus 220 is an apparatus that inspects whether the electronic component is normally mounted on the board.

The appearance inspection apparatus 230 and the X-ray inspection apparatus 240 are apparatuses that inspect whether the terminal of the electronic component disposed on the board is normally soldered on the land of the board with a visible ray or an X-ray. That is, the appearance inspection apparatus 230 and the X-ray inspection apparatus 240 are units that perform the inspection while the product is completed. The board determined to be detective is sorted as a defective, and sent to such an additional inspection as a visual inspection as needed. In the first embodiment, the inspection performed with the appearance inspection apparatus 230 or X-ray inspection apparatus 240 is referred to as a completion inspection, and a process of performing the completion inspection is referred to as a completion inspection process.

Each inspection apparatus is provided on the inspection line, and has a configuration that can inspect the board conveyed on the inspection line. When the inspection is completed, each inspection apparatus transmits the inspection result to the inspection management apparatus 250.

At this point, one of problems is that what causes the defect can hardly be identified even if the defect is detected in the completion inspection process. For example, in the case that a defect that "a fillet height is excessively low" is finally recognized, the defect is possibly caused by "shortage of solder" occurring in the solder printing process or "component deviation (in the electrode direction)" occurring in the component mounting process.

In order to prevent the defect from remaining up to the completion inspection process, originally it is preferable that an abnormality finally affecting the quality is detected in each of the soldering printing process (hereinafter, referred to as a printing process) and the component mounting process (hereinafter, referred to as a mount process). However, even if the solder amount or the component position deviates, although the deviation is not clearly an abnormal value, whether the defect occurs actually can hardly be recognized until the reflow process is completed. That is, the defect can hardly be decided until the process progresses. On the other hand, when a threshold for the abnormal value is strictly set, a probability of mistaking the nondefective for the defective increases to lead to excessive quality.

Therefore, when the defect is detected in the completion inspection, the quality management system of the first embodiment checks the deviation of the measured value by referring to the inspection result generated in the inspection process (hereinafter, referred to as a preceding process) before the completion inspection, estimates whether the deviation of the measured value is the factor causing the defect, and corrects the associated mounting parameter to perform the feedback to the production facility. Specifically, the analyzer 260 executes the following steps.

(1) The suspected inspection item associated with the detected defect is extracted.

In the case that the defect is detected in the completion inspection, the analyzer 260 extracts the suspected inspection item associated with the defect in the preceding process.

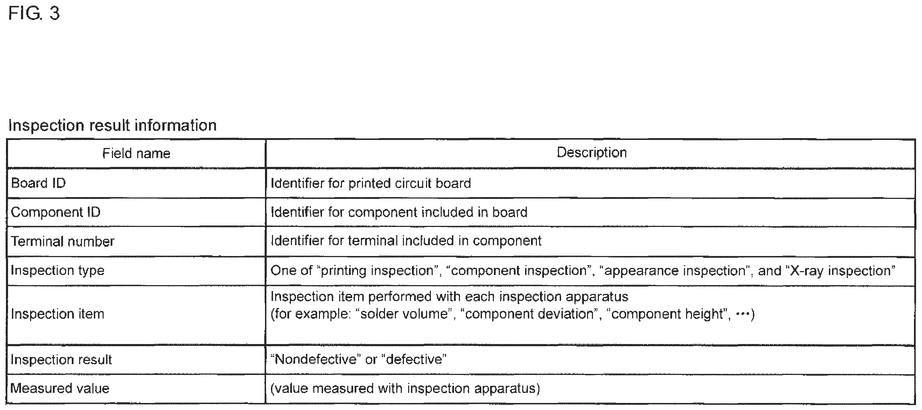

Fig. 3 illustrates a format example of an inspection result (hereinafter, referred to as inspection result information) accumulated in the inspection management apparatus 250. The inspection result is generated in each terminal that is of an inspection minimum unit. Because the solder printing inspection apparatus, the component inspection apparatus, the appearance inspection apparatus, and the X-ray inspection apparatus individually perform the inspection even in the identical terminal, the processes or items in each of which the inspection is performed are discriminated from one another by an "inspection type" field and an "inspection item" field.

The analyzer 260 acquires inspection result information recorded in the inspection management apparatus 250, extracts a record (that is, the inspection result generated in the completion inspection process), which has the inspection type of "appearance inspection" or "X-ray inspection", and checks the existence of the defect in each terminal.

In the first embodiment, it is assumed that the record having the defective inspection result exists even if the inspection item is the fillet height at a certain terminal.

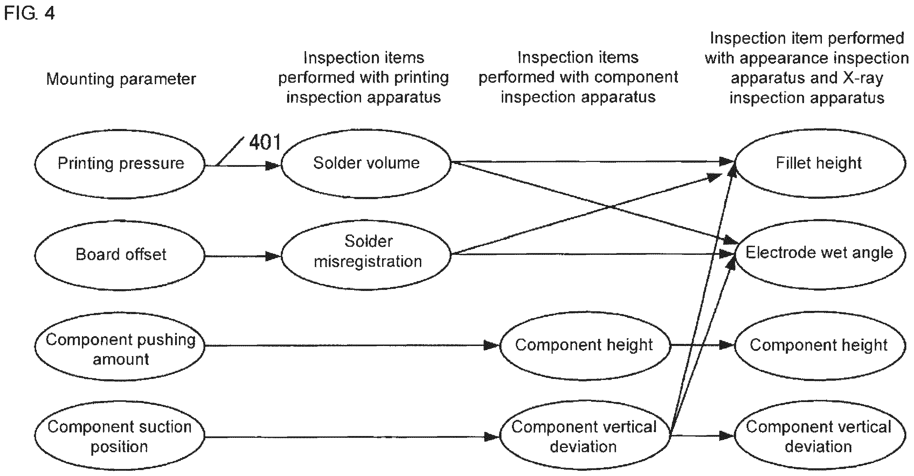

A causal relationship between the mounting parameter in the production facility and the inspection item performed with each inspection apparatus will be described below with reference to Fig. 4. An arrow in Fig. 4 expresses an influence in the case that the value varies. For example, the symbol 401 means that a variation in solder printing pressure influences the inspection item of a solder volume in the printing inspection.

As can be seen from the relationship of Fig. 4, the fillet height is influenced by three kinds of items, namely, a solder volume in the solder printing process, a solder misregistration in the solder printing process, and a component vertical deviation in the component mounting process. That is, the three kinds of items become the suspected inspection item associated with the detected defect in the preceding process. The analyzer 260 holds the relationship in Fig. 4, and extracts the corresponding inspection item (the inspection item in the preceding process) when the defect is detected in the completion inspection.

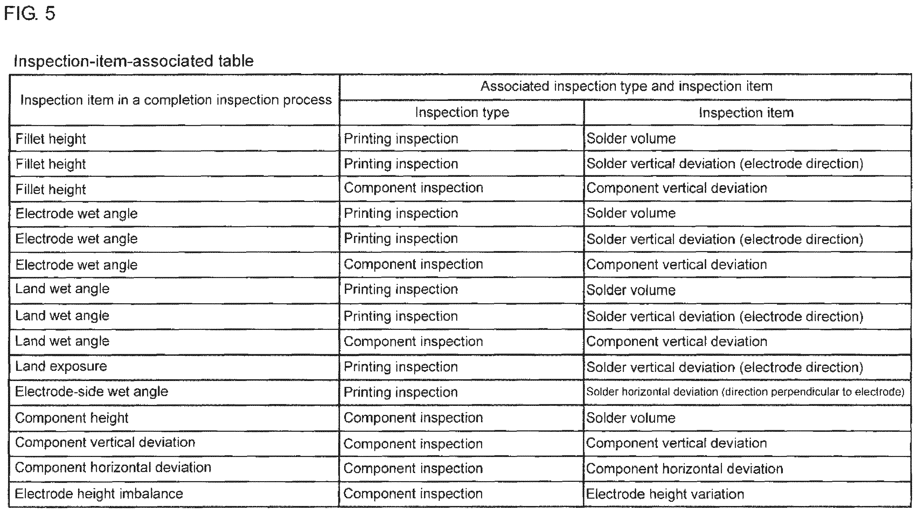

The analyzer 260 holds a relationship between the inspection items in the pieces of data in Fig. 4 as a table (hereinafter, referred to as an inspection-item-associated table). Fig. 5 illustrates an example of the inspection-item-associated table.

The inspection item in the completion inspection process and the inspection type and item in the preceding process, which are associated with the inspection item in question are recorded in the inspection-item-associated table. The analyzer 260 extracts the corresponding inspection item by referring to the inspection-item-associated table in the case that the defect is detected in the completion inspection process.

(2) A measured value distribution is acquired with respect to the extracted inspection item to determine the abnormality.

Then, with respect to the inspection item extracted in (1), the inspection result is acquired from the inspection management apparatus 250, and the measured value distribution is acquired. Whether the abnormality exists in the acquired measured value distribution is determined.

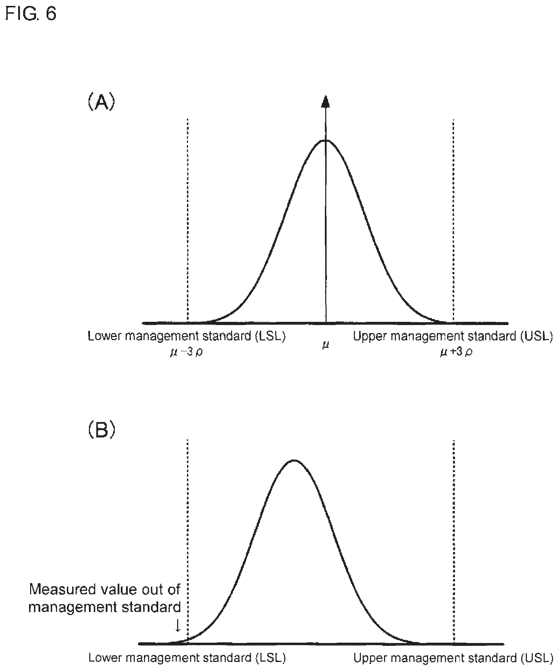

A method for determining whether the abnormality exists in the measured value distribution will be described below. Fig. 6(A) illustrates an example of the measured value distribution in the case that a certain inspection item (for example, solder volume) exists. It is assumed that $\mu$ is an average value of the solder volume in a nondefective lot, and that $\mu \pm 3\sigma$ are an Upper Specification Limit (USL) and a Lower Specification Limit (LSL), respectively. Where $\sigma$ is a standard deviation. The standard deviation is a value used to calculate a process capability index (hereinafter, referred to as Cpk). Cpk can be calculated by an equation (1). For Cpk of 1.0, 99.73% of the measured value falls within a range from LSL to USL.

[Mathematical formula 1]

$$Cpk = \min\left(\frac{USL - \mu}{3\sigma}, \frac{\mu - LSL}{3\sigma}\right) \quad \cdots \quad \text{Equation (1)}$$

The analyzer 260 determines whether the measured value distribution indicates the abnormality on the basis of Cpk. For example, as illustrated in Fig. 6(B), Cpk decreases below 1.0 when the number of measured values out of the management standard increases. Therefore, in the first embodiment, Cpk is calculated from the measured value, and the determination that the measured value distribution is abnormal is made when Cpk is less than 1.0.

For example, in the case that the inspection item extracted in (1) includes the solder volume, the solder misregistration, and the component vertical deviation, each of the corresponding measured values is acquired, and Cpk is individually calculated. In the case that only Cpk corresponding to the solder volume is less than 1.0, it is estimated that the excess or shortage of the solder volume is the factor of the defect detected in the completion inspection. Whether the solder is excessive or short can be determined by acquiring the direction exceeding the management standard.

(3) The mounting parameter corresponding to the inspection item in which the abnormality is detected is changed.

Then, the analyzer 260 changes the mounting parameter in order to remove the factor of the defect. For example, in the case that the solder volume is excessive, the solder printing apparatus 110 increases the printing pressure of the solder applied to the printed circuit board. In the case that the component deviates, a suction position where the mounter 120 lifts up the component using a vacuum nozzle is adjusted. The analyzer 260 holds information indicating how to correct the mounting parameter in the case that the measured value distribution is abnormal, and the analyzer 260 issues an instruction to the production facility management apparatus 140 to change the mounting parameter according to the information.

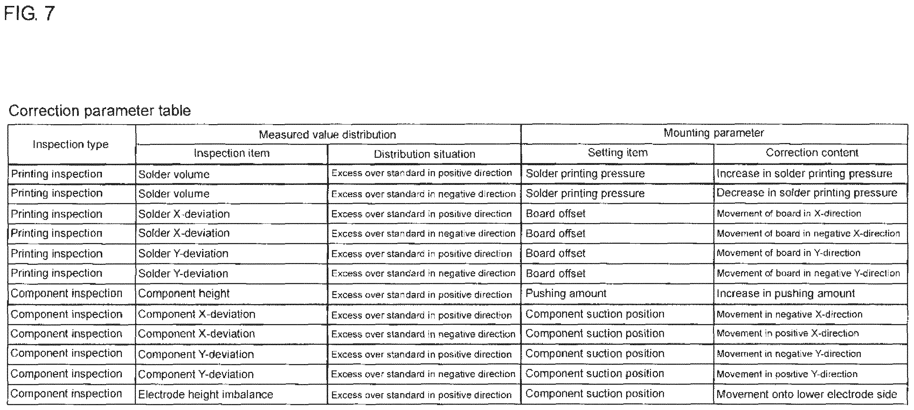

Fig. 7 illustrates an example of a table (correction parameter table) in which a distribution situation of the measured value and the mounting parameter to be corrected are correlated with each other. At this point, the measured value distribution becomes "excess over standard in positive direction" in the case that an excess amount of the measured value on the USL side is larger than that on the LSL side, and the measured value distribution becomes "excess over standard in negative direction" in the case that the excess amount of the measured value on the LSL side is larger than that on the USL side. That is, the measured value distribution becomes "excess over standard in negative direction" for

(USL - μ) / 3σ > (LSL - μ) / 3σ, and
the measured value distribution becomes "excess over standard in positive direction" for (USL - μ) / 3σ < (LSL - μ) / 3σ.

For example, the solder volume distribution is "excess over standard in positive direction", an instruction to increase the solder printing pressure is issued on the basis of the correction parameter table.

In the first embodiment, a deviation direction of the component or solder in the completion inspection is based on an orientation of the electrode, and it is assumed that a board coordinate system (for example, the lower left of the board is set to an origin, a right lateral direction is set to a position X-direction, and a vertical direction is set to a positive Y-direction) is used in the mounting parameter of the mounter. That is, in the case that the position of the solder or component is corrected, it is necessary to change an axis to be corrected according to the electrode direction. For example, in the case that the component vertical deviation is detected while the electrode is oriented toward a board right-left direction, a component X deviation is referred to in Fig. 7. For example, in the case that the component vertical deviation is detected while the electrode is oriented toward a board up and down direction, a component Y deviation is referred to in Fig. 7.

For (USL - μ) / 3σ = (LSL - μ) / 3σ, because the excessive amounts are equal to each other in the up and down direction, the countermeasure can hardly be taken by the correction of the mounting parameter. In such cases, desirably the mounting parameter is not changed, but a user is notified as needed.

(Processing flowchart)

A flowchart of the above pieces of processing performing the analyzer 260 will be described below in order to achieve the pieces of processing described above.

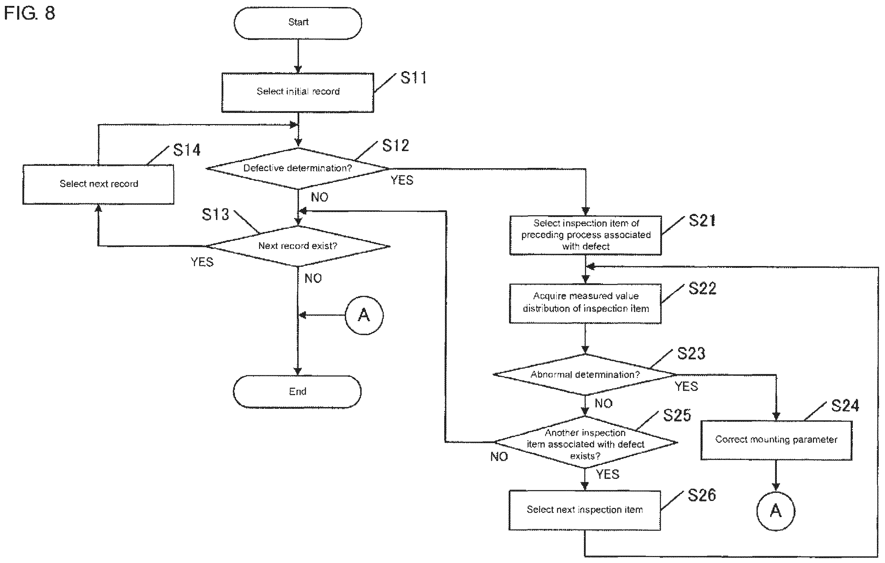

Fig. 8 is a flowchart illustrating quality management processing performed with the analyzer 260. The pieces of processing in Fig. 8 may be performed in each predetermined time such as one hour, or performed at a time point the production is ended with respect to a specific lot of the product. The pieces of processing in Fig. 8 may be performed every time the products are produced by the predetermined number of products.

In Step S11, the inspection result information generated in the completion inspection process is acquired from the inspection management apparatus 250, and an initial record is selected from unprocessed records.

In Step S12, whether the inspection result of the selected record is nondefective or defective is determined, and the processing goes to Step S13 when the inspection result is nondefective.

In Step S13, whether the unprocessed record remains is checked. The unprocessed record is selected (Step S14) when the unprocessed record remains, and the processing returns to Step S12. The processing is ended when the unprocessed record does not exist.

The processing goes to Step S21 when the inspection result is defective in Step S12.

In Step S21, the inspection type and item associated with the detected defect are selected in the preceding process by referring to the inspection-item-associated table. In the case that plural items associated with the defect exist, the initial inspection type and item are selected.

In Step S22, the record in which a board ID, a component ID, a terminal number, the inspection type, and the inspection item agree with those of the record selected in Step S21 is extracted from the inspection result information, and plural measured values corresponding to the selected inspection type and item are acquired. Therefore, for example, a solder volume distribution is obtained by the printing inspection at a specific terminal of a specific component.

The inspection result information may be acquired with respect to all the records. Preferably the inspection result information is acquired while divided in any unit such as units of lots, units of times, and units of the numbers of boards. Preferably new information is used compared with information in which a given time elapses after the inspection. For example, the latest lot in which the production is completed, the inspection results in last n hours, and the inspection results of last m records may be set to the target.

In Step S23, whether the acquired measured value distribution indicates the abnormality is determined. Specifically, the average and standard deviation of the measured value and the management standards (USL and LSL) are acquired to calculate Cpk using the equation (1).

As a result, when Cpk is less than 1.0, the determination that the measured value distribution of the inspection item is abnormal is made, and the processing goes to Step S24 to correct the mounting parameter.

The correction content of the mounting parameter is transmitted to the production facility management apparatus 140, and applied to the solder printing apparatus 110 and the mounter 120.

When the determination that the measured value distribution is normal is made in Step S23, namely, when Cpk is greater than or equal to 1.0, the processing goes to Step S25 to determine whether another inspection item associated with the detected defect exists. When another inspection item exists, the inspection item is selected in Step S26, and the processing returns to Step S22. When another inspection item does not exist, the processing goes to Step S13 to process the next record of the inspection result information.

As described above, in the quality management system of the first embodiment, when the defect is detected in the completion inspection, the factor of the defect is estimated by referring to the measured value distribution in the intermediate process, and the associated mounting parameter is corrected. Therefore, even if the defect occurs in the finished product due to some cause in the surface mounting line in which the board is produced through the plural processes, the parameter can be corrected in the direction in which the defect is prevented. Because of no necessity to stop the line for the purpose of the countermeasure, only the defective can be suppressed while production efficiency is maintained.

(Second embodiment)

In the first embodiment, as described in Steps S22 and S23, Cpk is calculated from the measured value distribution in the printing inspection and the component inspection, and the determination that the abnormality occurs is made in the case that Cpk is less than 1.0. On the other hand, in a second embodiment, the abnormality is determined with Cpk in the lot in which the defective occurs actually as the threshold.

In the second embodiment, a process capability index (hereinafter, referred to as $Cpk_T$) that becomes the threshold in making the abnormal determination of Step S23 is set through the following pieces of processing, and the occurrence of the abnormality is determined in the case that the calculated Cpk is less than $Cpk_T$.

The following pieces of processing are performed independently of the pieces of processing in Fig. 8. For example, the following pieces of processing are performed every time the lot production is ended.

(1) In the case that the defective is included in the latest production lot

In the case that the defective is included in the latest production lot, the measured value distribution corresponding to the inspection item (the inspection item in the preceding process) associated with the defect is acquired, and the process capability index calculated from the measured value distribution is set to $Cpk_T$ in the inspection item.

For example, in the first embodiment, the abnormal determination is made when Cpk is less than 1.0 (for example, 0.9). On the other hand, in the second embodiment, the abnormal determination is made with 0.9 of the actually-achieved value as the threshold.

When the calculated Cpk is greater than or equal to 1.0, it is considered that the inspection item is not associated with the defect. In this case, $Cpk_T$ for the inspection item is a specified value (for example, 1.0).

(2) In the case that the defective is not included in the latest production lot

In the case that the defective is not included in the latest production lot, $Cpk_T$ is set to 1.0 similarly to the first embodiment. The same holds true for the case that the latest production lot does not exist. $Cpk_T$ is not necessarily 1.0, but any value less than 1.0 may be adopted.

Thus, in the second embodiment, Cpk is calculated in the lot in which the defect occurs actually, and adopted as the threshold for the abnormal determination in Step S23. Therefore, because the threshold is set on the basis of the past actual production, the abnormal determination can be made with higher accuracy.

In the second embodiment, Cpk calculated in the lot in which the defect occurs is set to the threshold. Alternatively, the threshold is not necessarily a value equal to Cpk, but the threshold may be a value based on Cpk. For example, a value having a certain amount of margin may be set to the threshold.

In the second embodiment, $Cpk_T$ is calculated in units of lots. Any unit such as units of times and units of the numbers of boards may be adopted as the calculated unit. For example, $Cpk_T$ may be re-calculated in each predetermined time.

(Third embodiment)

In the first and second embodiments, the inspection-item-associated table in Fig. 5 is stored in the analyzer 260, and the inspection item associated with the defect is acquired by referring to the inspection-item-associated table. On the other hand, in a third embodiment, a correlation between the measured value in the completion inspection and the measured value in the preceding process is obtained to automatically generate the inspection-item-associated table.

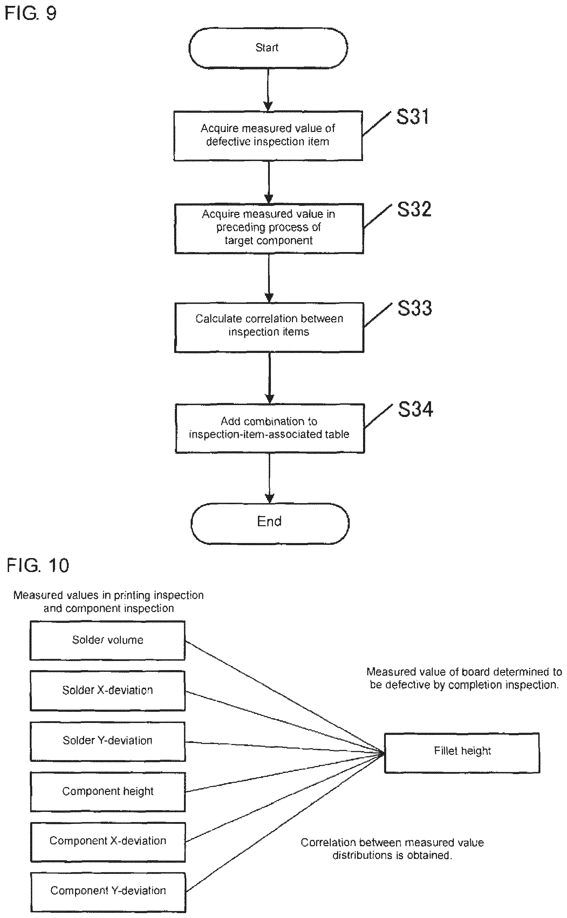

In the third embodiment, the inspection-item-associated table used in Step S21 is generated through a flow in Fig. 9. The following pieces of processing in Fig. 9 are performed independently of the pieces of processing in Fig. 8. In the third embodiment, the pieces of processing in Fig. 9 are performed every time the lot production is ended. Alternatively, the pieces of processing in Fig. 9 may be performed every time a predetermined time elapses or every time the predetermined number of boards is produced.

In the case that the production lot includes the product determined to be defective by the completion inspection, the past measured value is collected with respect to the inspection item in which the defect is detected (Step S31). A collection target may be only the terminal where the defect occurs, or the component having a high possibility of the occurrence of the similar defect may be included in the collection target. For example, the component having the high possibility of the occurrence of the similar defect can be defined as follows. Obviously the component having the high possibility of the occurrence of the similar defect may be defined in any way.

(1) The component having the same product number as the component in which the defect occurs
(2) The component mounted with the same nozzle as the component in which the defect occurs
(3) The component mounted at the same position as the component in which the defect occurs
(4) The component mounted on the same board as the component in which the defect occurs

Preferably a collection range is divided in any unit such as units of lots, units of times, and units of the numbers of boards. For example, the collection range may be set to 20 last produced boards.

The inspection result in the preceding process, which corresponds to the component in question, is acquired, and the measured value is collected with respect to all the inspection items (Step S32). Therefore, as illustrated in Fig. 10, the measured value distribution is acquired in a one-to-many manner. The collection range of the measured value is similar to that in Step S31.

The correlation between the acquired measured value distributions is obtained (Step S33), and a combination recognized to be correlatable is added to the inspection-item-associated table (Step S34). The term "correlatable" includes the case that a correlation coefficient is greater than or equal to a predetermined value.

For example, in the case that the measured value distribution for the fillet height and the measured value distribution for the solder volume are recognized to be correlatable with each other, the initial record of the table in Fig. 5 is generated.

Because the measured value depends on the component or terminal, the measured value may be normalized as needed.

Thus, in the third embodiment, the inspection-item-associated table suitable for the actual situation can be generated by obtaining the correlation between the inspection items, and the quality management can be performed with higher accuracy.

The generated inspection-item-associated table may be remade when a predetermined time elapses, or the record that becomes old to a certain extent may be deleted when the new record is added. Therefore, the table that always reflects the latest state can be maintained.

(Modifications of third embodiment)

In the third embodiment, the correlation between the inspection items is determined by calculating the correlation coefficient. Alternatively, the correlation between the inspection items may be determined by another method.

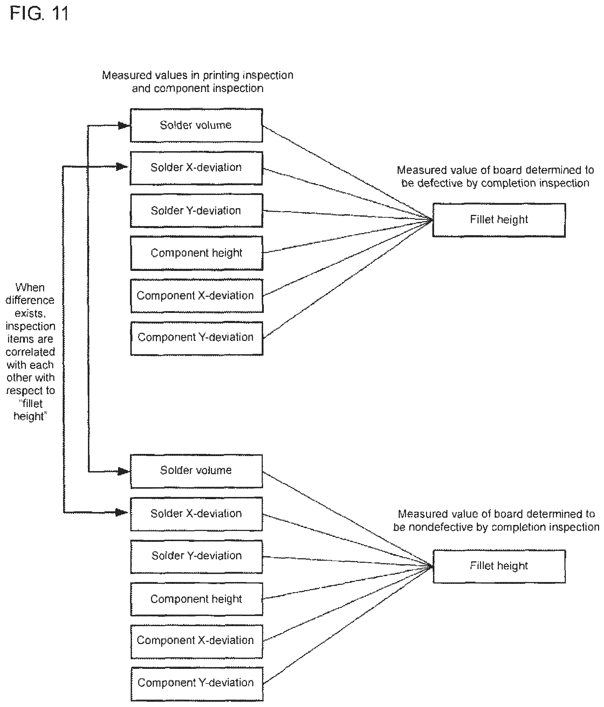

For example, in the case that a certain lot includes the product determined to be defective by the completion inspection, whether the inspection items are correlated with each other can be obtained by the following method (see Fig. 11).

(1) The measured value is collected with respect to all the inspection items in the preceding process in the lot including the product determined to be defective.
(2) The measured value is collected with respect to all the inspection items in the preceding process in the lot that does not includes the product determined to be defective.
(3) The measured value distributions corresponding to the identical inspection item are compared to each other to determine whether a difference exists.

When the difference is recognized, it can be estimated that the inspection item is associated with the inspection item in which the defect occurs. For example, whether the difference between the measured value distributions exists can be determined by such a test method as a t-test.

The correlation between the inspection items may be determined by a method described in Japanese Patent No. 5017943.

(Modifications)

The above embodiments are only illustrative for the purpose of the description of the present invention, and various changes and combinations can properly be made without departing from the scope of the present invention.

For example, in the above embodiment, the mounting parameter is automatically applied to the production facility when corrected in Step S24. Alternatively, the mounting parameter may be applied to the production facility by a user operation after the information is presented to the user. In this case, preferably the user selects whether the corrected mounting parameter is applied after the correction target parameter, the content of the detected defect, the estimated measurement item associated with the defect, the threshold ($Cpk_T$) used in the determination, and the actual Cpk are output to a display (not illustrated). The changed mounting parameter may be fed back to the production facility by a method except for the illustrative method. For example, the user who checks the output display may manually change the mounting parameter. The output method is not limited to the screen display. For example, the output may be written, or another output unit may be used.

In the above embodiments, the analyzer 260 periodically performs the pieces of processing in Fig. 8. Alternatively, the pieces of processing in Fig. 8 may be started by another trigger. For example, the pieces of processing in Fig. 8 may be started by the user operation, or started every time the defective is detected in the completion inspection or another additional inspection.

In the above embodiments, the threshold of the abnormal determination is decided on the basis of the process capability index. Alternatively, the threshold of the abnormal determination may be decided using another index as long as the threshold is a value indicating the quality. For example, permissible upper and lower limits are set, and the abnormal determination may be made when the measured value is distributed while exceeding the permissible upper and lower limits. Any method may be adopted in the abnormal determination of Step S23 as long as how to correct the mounting parameter can be decided.

DESCRIPTION OF SYMBOLS

| | |
|---|---|
| 110 | Solder printing apparatus |
| 120 | Mounter |
| 130 | Reflow furnace |
| 140 | Production facility management apparatus |
| 210 | Solder printing inspection apparatus |
| 220 | Component inspection apparatus |
| 230 | Appearance inspection apparatus |
| 240 | X-ray inspection apparatus |
| 250 | Inspection management apparatus |
| 260 | Analyzer |
| 270 | Workstation |

**Claims**

1.  A quality management apparatus (250) that is adapted to manage a surface mounting line comprising a solder printing apparatus (110) configured to print solder on a printed circuit board, a mounter (120) configured to dispose an electronic component on the printed circuit board, a first inspection apparatus (210, 220) configured to inspect a solder printing state and an electronic component disposition state, a reflow furnace (130) configured to solder the electronic component, and a second inspection apparatus (230, 240) configured to inspect a bonding state of the electronic component and the printed circuit board, the quality management apparatus (240) comprising:

    a defective factor estimator configured to extract, when the second inspection apparatus (230, 240) detects a defect, an inspection item being determined from a measurement result that is estimated to be associated with a defect in inspection items being determined from measurement results inspected with the first inspection apparatus (210, 220);
    a quality determination unit configured to acquire a distribution being determined from measurement results in the estimated inspection item as an inspection result corresponding to the extracted inspection item from the first inspection apparatus (210, 220), and to determine whether the inspection result indicates an abnormality based on whether values of said distribution being determined from measurement results exceed an abnormal determination criterion; and
    a parameter changer configured to decide a parameter to be changed and a content of the parameter in parameters used in the solder printing apparatus (110) or the mounter (120) when the inspection result indicates the abnormality,
    wherein, when one of an excessive amount on an upper limit side of the abnormal determination criterion and an excessive amount on a lower limit side is larger than the other in the acquired distribution being determined from measurement results the parameter changer decides the parameter to be changed and the content of the parameter such that the distribution being determined from measurement results is moved in a direction in which ununiformity of the excessive amount is solved.

2. The quality management apparatus (250) according to claim 1, wherein the quality determination unit is adapted to calculate a process capability index in a predetermined collecting unit from the inspection result acquired from the first inspection apparatus (210, 220), and to set the abnormal determination criterion based on the process capability index when a defective product is included in the collecting unit.

3. The quality management apparatus (250) according to claim 2, wherein the quality determination unit is adapted to periodically acquire the inspection result from the first inspection apparatus (210, 220) to update the abnormal determination criterion.

4. The quality management apparatus (250) according to any one of claims 1 to 3, wherein the parameter changer is adapted to apply the decided parameter to be changed to the solder printing apparatus (110) or the mounter (120).

5. The quality management apparatus (250) according to any one of claims 1 to 3, further comprising
an output unit configured to output information to a user,
wherein the parameter changer is adapted to output the decided parameter to be changed through the output unit.

6. The quality management apparatus (250) according to claim 5, wherein the output unit is a display apparatus, and the parameter changer is adapted to output at least one of a content of the defect detected with the second inspection apparatus (230, 240), the inspection item estimated to be associated with the defect, whether the inspection result corresponding to the inspection item indicates the abnormality, and the parameter to be changed and the content of the parameter through the output unit when the parameter to be changed is decided.

7. The quality management apparatus (250) according to any one of claims 1 to 6, further comprising
an association degree calculator configured to obtain an association degree between inspection items by comparing the inspection result of the second inspection apparatus (230, 240) to the inspection result of the first inspection apparatus (210, 220) to obtain a correlation between the measured values,
wherein the defective factor estimator is adapted to extract the inspection item estimated to be associated with the detected defect based on the association degree between the inspection items.

8. A method for controlling a quality management apparatus (250) configured to manage a surface mounting line comprising a solder printing apparatus (110) configured to print solder on a printed circuit board, a mounter (120) configured to dispose an electronic component on the printed circuit board, a first inspection apparatus (210, 220) configured to inspect a solder printing state and an electronic component disposition state, a reflow furnace (130) configured to solder the electronic component, and a second inspection apparatus (230, 240) configured to inspect a bonding state of the electronic component and the printed circuit board, the quality management apparatus controlling method comprising steps of:

extracting, when the second inspection apparatus (230, 240) detects a defect, an inspection item being determined from a measurement result
that is estimated to be associated with the defect in inspection items being determined from measurement results inspected with the first inspection apparatus (210, 220);
acquiring a distribution being determined from measurement results in the estimated inspection item as an inspection result corresponding to the extracted inspection item from the first inspection apparatus (210, 220), and determining whether the inspection result indicates an abnormality based on whether values of said distribution being determined from measurement results exceed an abnormal determination criterion; and
deciding a parameter to be changed and a content of the parameter in parameters used in the solder printing apparatus (110) or the mounter (120) when the inspection result indicates the abnormality,
wherein, in the parameter changing step, when one of an excessive amount on an upper limit side of the abnormal determination criterion and an excessive amount on a lower limit side is larger than the other in the acquired distribution being determined from measurement results the parameter to be changed and the content of the parameter are decided such that the distribution being determined from measurement results is moved in a direction in which ununiformity of the excessive amount is solved.

9. A program that causes a computer to perform each step of the quality management apparatus controlling method according to claim 8.

**Patentansprüche**

1. Qualitätsverwaltungsvorrichtung (250), die dafür ausgelegt ist, eine Oberflächenmontagelinie umfassend eine Lötpastendruckvorrichtung (110) gestaltet zum Drucken von Lötpaste auf eine gedruckte Schaltungsplatte, einen Bestücker (120) gestaltet zum Anordnen einer elektronischen Komponente auf der gedruckten Schaltungsplatte, eine erste Inspektionsvorrichtung (210, 220) gestaltet zum Inspizieren eines Lötpastendruckzustands und eines Anordnungszustands der elektronischen Komponente, einen Aufschmelzofen (130) gestaltet zum Löten der elektronischen Komponente, und eine zweite Inspektionsvorrichtung (230, 240) gestaltet zum Inspizieren eines Bindungszustands der elektronischen Komponente und der gedruckten Schaltungsplatte, zu verwalten, wobei die Qualitätsverwaltungsvorrichtung (240) umfasst:

eine Fehlerfaktor-Einschätzvorrichtung, die dafür gestaltet ist, wenn die zweite Inspektionsvorrichtung (230, 240) einen Fehler erkennt, einen aus einem Messergebnis ermittelten Inspektionspunkt zu extrahieren, der voraussichtlich mit einem Fehler in Inspektionspunkten, die aus Messergebnissen, die mit der ersten Inspektionsvorrichtung (210, 220) inspiziert worden sind, ermittelt worden sind, in Zusammenhang steht;

eine Qualitätsbestimmungseinheit, die dafür gestaltet ist, eine aus Messergebnissen ermittelte Verteilung im voraussichtlichen Inspektionspunkt als ein Inspektionsergebnis entsprechend dem von der ersten Inspektionsvorrichtung (210, 220) extrahierten Inspektionspunkt zu erlangen, und basierend darauf, ob Werte der aus Messergebnissen bestimmten Verteilung ein anomales Bestimmungskriterium übersteigen, zu ermitteln, ob das Inspektionsergebnis eine Anomalie anzeigt; und

einen Parameterwechsler, der dafür gestaltet ist, einen zu verändernden Parameter und einen Inhalt des Parameters aus in der Lötpastendruckvorrichtung (110) oder im Bestücker (120) verwendeten Parametern zu bestimmen, wenn das Inspektionsergebnis die Anomalie anzeigt,

wobei, wenn entweder eine überschüssige Menge betreffend eine Obergrenze des anomalen Bestimmungskriteriums oder eine überschüssige Menge betreffend eine Untergrenze in der erlangten Verteilung, die aus Messergebnissen ermittelt worden ist, größer ist, als die andere, der Parameterwechsler den zu verändernden Parameter und den Inhalt des Parameters derart bestimmt, dass die aus Messergebnissen bestimmte Verteilung in einer Richtung bewegt wird, in welcher die Ungleichmäßigkeit der überschüssigen Menge gelöst wird.

2. Qualitätsverwaltungsvorrichtung (250) nach Anspruch 1, wobei die Qualitätsbestimmungseinheit dafür ausgelegt ist, in einer vorher festgelegten Aufnahmeeinheit aus dem von der ersten Inspektionsvorrichtung (210, 220) erlangten Inspektionsergebnis einen Prozessfähigkeitsindex zu berechnen, und das anomale Bestimmungskriterium basierend auf dem Prozessfähigkeitsindex einzustellen, wenn in der Aufnahmeeinheit ein fehlerhaftes Produkt enthalten ist.

3. Qualitätsverwaltungsvorrichtung (250) nach Anspruch 2, wobei die Qualitätsbestimmungseinheit dafür ausgelegt ist, regelmäßig das Inspektionsergebnis von der ersten Inspektionsvorrichtung (210, 220) zu erfassen, um das anomale Bestimmungskriterium zu aktualisieren.

4. Qualitätsverwaltungsvorrichtung (250) nach einem der Ansprüche 1 bis 3, wobei der Parameterwechsler dafür ausgelegt ist, den zum Verändern bestimmten Parameter auf die Lötpastendruckvorrichtung (110) oder den Bestücker (120) anzuwenden.

5. Qualitätsverwaltungsvorrichtung (250) nach einem der Ansprüche 1 bis 3, ferner umfassend
eine Ausgabeeinheit, die dafür gestaltet ist, Informationen an einen Benutzer auszugeben,
wobei der Parameterwechsler dafür ausgelegt ist, den zum Verändern bestimmten Parameter durch die Ausgabeeinheit auszugeben.

6. Qualitätsverwaltungsvorrichtung (250) nach Anspruch 5, wobei die Ausgabeeinheit eine Anzeigevorrichtung ist, und der Parameterwechsler dafür ausgelegt ist, mindestens entweder einen Inhalt des mit der zweiten Inspektionsvorrichtung (230, 240) erkannten Fehlers, den voraussichtlich mit dem Fehler in Zusammenhang stehenden Inspektionspunkt, ob das dem Inspektionspunkt entsprechende Inspektionsergebnis die Anomalie anzeigt, und/oder den zu verändernden Parameter und den Inhalt des Parameters durch die Ausgabeeinheit auszugeben, wenn der zu verändernde Parameter bestimmt worden ist.

7. Qualitätsverwaltungsvorrichtung (250) nach einem der Ansprüche 1 bis 6, ferner umfassend
einen Zusammenhangsgradrechner, der dafür gestaltet ist einen Grad des Zusammenhangs zwischen Inspektionspunkten durch Vergleichen des Inspektionsergebnisses der zweiten Inspektionsvorrichtung (230, 240) mit dem Inspektionsergebnis der ersten Inspektionsvorrichtung (210, 220) zu erlangen, um eine Korrelation zwischen den gemessenen Werten zu erlangen,
wobei die Fehlerfaktor-Einschätzvorrichtung dafür ausgelegt ist, den Inspektionspunkt, der basierend auf dem Grad des Zusammenhangs zwischen den Inspektionspunkten voraussichtlich mit dem erkannten Fehler in Zusammenhang steht, zu extrahieren.

8. Verfahren zum Steuern einer Qualitätsverwaltungsvorrichtung (250), die dafür ausgelegt ist, eine Oberflächenmontagelinie umfassend eine Lötpastendruckvorrichtung (110) gestaltet zum Drucken von Lötpaste auf eine gedruckte Schaltungsplatte, einen Bestücker (120) gestaltet zum Anordnen einer elektronischen Komponente auf der gedruckten Schaltungsplatte, eine erste Inspektionsvorrichtung (210, 220) gestaltet zum Inspizieren eines Lötpastendruckzustands und eines Anordnungszustands der elektronischen Komponente, einen Aufschmelzofen (130) gestaltet zum Löten der elektronischen Komponente, und eine zweite Inspektionsvorrichtung (230, 240) gestaltet zum Inspizieren eines Bindungszustands der elektronischen Komponente und der gedruckten Schaltungsplatte, zu verwalten, das Qualitätsverwaltungsvorrichtungs-Steuerungsverfahren umfassend die Schritte:

wenn die zweite Inspektionsvorrichtung (230, 240) einen Fehler erkennt, Extrahieren eines aus einem Messergebnis ermittelten Inspektionspunkts, der voraussichtlich mit dem Fehler in aus Messergebnissen ermittelten Inspektionspunkten, die mit der ersten Inspektionsvorrichtung (210, 220) inspiziert worden sind, in Zusammenhang steht;
Erlangen einer aus Messergebnissen ermittelten Verteilung im voraussichtlichen Inspektionspunkt als ein Inspektionsergebnis entsprechend dem extrahierten Inspektionspunkt aus der ersten Inspektionsvorrichtung (210, 220), und Ermitteln, basierend darauf, ob Werte der aus Messergebnissen bestimmten Verteilung ein anomales Bestimmungskriterium übersteigen, ob das Inspektionsergebnis eine Anomalie anzeigt; und
Bestimmen eines zu verändernden Parameters und eines Inhalts des Parameters aus in der Lötpastendruckvorrichtung (110) oder dem Bestücker (120) verwendeten Parametern, wenn das Inspektionsergebnis die Anomalie anzeigt,
wobei im Parameterveränderungsschritt, wenn entweder eine überschüssige Menge betreffend eine Obergrenze des anomalen Bestimmungskriteriums oder eine überschüssige Menge betreffend eine Untergrenze in der erlangten Verteilung, die aus Messergebnissen ermittelt worden ist, größer ist, als die andere, der zu verändernde Parameter und der Inhalt des Parameters derart bestimmt werden, dass die aus Messergebnissen bestimmte Verteilung in einer Richtung bewegt wird, in welcher die Ungleichmäßigkeit der überschüssigen Menge gelöst wird.

9. Programm, welches bewirkt, dass ein Computer jeden der Schritte des Qualitätsverwaltungsvorrichtungs-Steuerungsverfahrens nach Anspruch 8 ausführt.

**Revendications**

1. Appareil de gestion de la qualité (250) qui est adapté pour gérer une ligne de montage en surface comprenant un appareil d'impression de brasure (110) configuré pour imprimer une brasure sur une carte de circuit imprimé, un appareil monteur (120) configuré pour disposer un composant électronique sur la carte de circuit imprimé, un premier appareil d'inspection (210, 220) configuré pour inspecter un état d'impression de brasure et un état de disposition de composant électronique, un four de refusion (130) configuré pour braser le composant électronique, et un second appareil d'inspection (230, 240) configuré pour inspecter un état de liaison du composant électronique et de la carte de circuit imprimé, l'appareil de gestion de la qualité (240) comprenant :

un estimateur de facteur défectueux configuré pour extraire, lorsque le second appareil d'inspection (230, 240) détecte un défaut, un élément d'inspection déterminé à partir d'un résultat de mesure qui est estimé comme étant associé à un défaut dans des éléments d'inspection déterminés à partir de résultats de mesure inspectés avec le premier appareil d'inspection (210, 220) ;
une unité de détermination de la qualité configurée pour acquérir une distribution déterminée à partir de résultats de mesure dans l'élément d'inspection estimé en tant que résultat d'inspection correspondant à l'élément d'inspection extrait depuis le premier appareil d'inspection (210, 220), et pour déterminer si le résultat d'inspection indique une anomalie sur la base de si des valeurs de ladite distribution déterminée à partir de résultats de mesure dépassent un critère de détermination anormal ; et

un changeur de paramètre configuré pour décider d'un paramètre à changer et d'un contenu du paramètre dans des paramètres utilisés dans l'appareil d'impression de brasure (110) ou l'appareil monteur (120) lorsque le résultat d'inspection indique l'anomalie,

dans lequel, lorsque l'une d'une quantité excessive sur un côté limite supérieure du critère de détermination anormal et d'une quantité excessive sur un côté limite inférieure est plus grande que l'autre dans la distribution acquise déterminée à partir de résultats de mesure, le changeur de paramètre décide du paramètre à changer et du contenu du paramètre de sorte que la distribution déterminée à partir de résultats de mesure soit déplacée dans une direction dans laquelle une non-uniformité de la quantité excessive est résolue.

2. Appareil de gestion de la qualité (250) selon la revendication 1, dans lequel l'unité de détermination de la qualité est adaptée pour calculer un indice de capacité de processus dans une unité de collecte prédéterminée à partir du résultat d'inspection acquis depuis le premier appareil d'inspection (210, 220), et pour fixer le critère de détermination anormal sur la base de l'indice de capacité de processus lorsqu'un produit défectueux est inclus dans l'unité de collecte.

3. Appareil de gestion de la qualité (250) selon la revendication 2, dans lequel l'unité de détermination de la qualité est adaptée pour acquérir périodiquement le résultat d'inspection depuis le premier appareil d'inspection (210, 220) pour mettre à jour le critère de détermination anormal.

4. Appareil de gestion de la qualité (250) selon l'une quelconque des revendications 1 à 3, dans lequel le changeur de paramètre est adapté pour appliquer le paramètre à changer décidé à l'appareil d'impression de brasure (110) ou à l'appareil monteur (120).

5. Appareil de gestion de la qualité (250) selon l'une quelconque des revendications 1 à 3, comprenant en outre une unité de sortie configurée pour fournir en sortie des informations à un utilisateur,

dans lequel le changeur de paramètre est adapté pour fournir en sortie le paramètre à changer décidé par le biais de l'unité de sortie.

6. Appareil de gestion de la qualité (250) selon la revendication 5, dans lequel l'unité de sortie est un appareil d'affichage, et

le changeur de paramètre est adapté pour fournir en sortie au moins l'un d'un contenu du défaut détecté avec le second appareil d'inspection (230, 240), de l'élément d'inspection estimé comme étant associé au défaut, de si le résultat d'inspection correspondant à l'élément d'inspection indique l'anomalie, et du paramètre à changer et du contenu du paramètre par le biais de l'unité de sortie lorsque le paramètre à changer est décidé.

7. Appareil de gestion de la qualité (250) selon l'une quelconque des revendications 1 à 6, comprenant en outre un calculateur de degré d'association configuré pour obtenir un degré d'association entre des éléments d'inspection en comparant le résultat d'inspection du second appareil d'inspection (230, 240) au résultat d'inspection du premier appareil d'inspection (210, 220) pour obtenir une corrélation entre les valeurs mesurées,

dans lequel l'estimateur de facteur défectueux est adapté pour extraire l'élément d'inspection estimé comme étant associé au défaut détecté sur la base du degré d'association entre les éléments d'inspection.

8. Méthode de commande d'un appareil de gestion de la qualité (250) configuré pour gérer une ligne de montage en surface comprenant un appareil d'impression de brasure (110) configuré pour imprimer une brasure sur une carte de circuit imprimé, un appareil monteur (120) configuré pour disposer un composant électronique sur la carte de circuit imprimé, un premier appareil d'inspection (210, 220) configuré pour inspecter un état d'impression de brasure et un état de disposition de composant électronique, un four de refusion (130) configuré pour braser le composant électronique, et un second appareil d'inspection (230, 240) configuré pour inspecter un état de liaison du composant électronique et de la carte de circuit imprimé, la méthode de commande d'appareil de gestion de la qualité comprenant des étapes de :

extraction, lorsque le second appareil d'inspection (230, 240) détecte un défaut, d'un élément d'inspection déterminé à partir d'un résultat de mesure qui est estimé comme étant associé au défaut dans des éléments d'inspection déterminés à partir de résultats de mesure inspectés avec le premier appareil d'inspection (210, 220);

acquisition d'une distribution déterminée à partir de résultats de mesure dans l'élément d'inspection estimé en tant que résultat d'inspection correspondant à l'élément d'inspection extrait depuis le premier appareil d'inspection (210, 220), et détermination de si le résultat d'inspection indique une anomalie sur la base de si des valeurs de ladite distribution déterminée à partir de résultats de mesure dépassent un critère de détermination anormal ; et

décision d'un paramètre à changer et d'un contenu du paramètre dans des paramètres utilisés dans l'appareil d'impression de brasure (110) ou l'appareil monteur (120) lorsque le résultat d'inspection indique l'anomalie, dans lequel, à l'étape de changement de paramètre, lorsque l'une d'une quantité excessive sur un côté limite supérieure du critère de détermination anormal et d'une quantité excessive sur un côté limite inférieure est plus grande que l'autre dans la distribution acquise déterminée à partir de résultats de mesure, le paramètre à changer et le contenu du paramètre sont décidés de sorte que la distribution déterminée à partir de résultats de mesure soit déplacée dans une direction dans laquelle une non-uniformité de la quantité excessive est résolue.

9. Programme qui amène un ordinateur à réaliser chaque étape de la méthode de commande d'appareil de gestion de la qualité selon la revendication 8.

FIG. 1

FIG. 2

## FIG. 3

Inspection result information

| Field name | Description |
|---|---|
| Board ID | Identifier for printed circuit board |
| Component ID | Identifier for component included in board |
| Terminal number | Identifier for terminal included in component |
| Inspection type | One of "printing inspection", "component inspection", "appearance inspection", and "X-ray inspection" |
| Inspection item | Inspection item performed with each inspection apparatus<br>(for example: "solder volume", "component deviation", "component height", ⋯) |
| Inspection result | "Nondefective" or "defective" |
| Measured value | (value measured with inspection apparatus) |

FIG. 4

## FIG. 5

Inspection-item-associated table

| Inspection item in a completion inspection process | Associated inspection type and inspection item | |
| --- | --- | --- |
| | Inspection type | Inspection item |
| Fillet height | Printing inspection | Solder volume |
| Fillet height | Printing inspection | Solder vertical deviation (electrode direction) |
| Fillet height | Component inspection | Component vertical deviation |
| Electrode wet angle | Printing inspection | Solder volume |
| Electrode wet angle | Printing inspection | Solder vertical deviation (electrode direction) |
| Electrode wet angle | Component inspection | Component vertical deviation |
| Land wet angle | Printing inspection | Solder volume |
| Land wet angle | Printing inspection | Solder vertical deviation (electrode direction) |
| Land wet angle | Component inspection | Component vertical deviation |
| Land exposure | Printing inspection | Solder vertical deviation (electrode direction) |
| Electrode-side wet angle | Printing inspection | Solder horizontal deviation (direction perpendicular to electrode) |
| Component height | Component inspection | Solder volume |
| Component vertical deviation | Component inspection | Component vertical deviation |
| Component horizontal deviation | Component inspection | Component horizontal deviation |
| Electrode height imbalance | Component inspection | Electrode height variation |

EP 3 102 018 B1

FIG. 6

(A)

Lower management standard (LSL)     $\mu$     Upper management standard (USL)
$\mu - 3\rho$                                    $\mu + 3\rho$

(B)

Measured value out of
management standard
↓

Lower management standard (LSL)          Upper management standard (USL)

FIG. 7

Correction parameter table

| Inspection type | Measured value distribution | | Mounting parameter | |
|---|---|---|---|---|
| | Inspection item | Distribution situation | Setting item | Correction content |
| Printing inspection | Solder volume | Excess over standard in positive direction | Solder printing pressure | Increase in solder printing pressure |
| Printing inspection | Solder volume | Excess over standard in negative direction | Solder printing pressure | Decrease in solder printing pressure |
| Printing inspection | Solder X-deviation | Excess over standard in positive direction | Board offset | Movement of board in X-direction |
| Printing inspection | Solder X-deviation | Excess over standard in negative direction | Board offset | Movement of board in negative X-direction |
| Printing inspection | Solder Y-deviation | Excess over standard in positive direction | Board offset | Movement of board in Y-direction |
| Printing inspection | Solder Y-deviation | Excess over standard in negative direction | Board offset | Movement of board in negative Y-direction |
| Component inspection | Component height | Excess over standard in positive direction | Pushing amount | Increase in pushing amount |
| Component inspection | Component X-deviation | Excess over standard in positive direction | Component suction position | Movement in negative X-direction |
| Component inspection | Component X-deviation | Excess over standard in negative direction | Component suction position | Movement in positive X-direction |
| Component inspection | Component Y-deviation | Excess over standard in positive direction | Component suction position | Movement in negative Y-direction |
| Component inspection | Component Y-deviation | Excess over standard in negative direction | Component suction position | Movement in positive Y-direction |
| Component inspection | Electrode height imbalance | Excess over standard in positive direction | Component suction position | Movement onto lower electrode side |

FIG. 8

Start

Select initial record — S11

S14

Select next record

S12
Defective determination?

YES

NO

S13
Next record exist?

YES

NO

A

End

S21
Select inspection item of preceding process associated with defect

S22
Acquire measured value distribution of inspection item

S23
Abnormal determination?

YES

NO

S25
Another inspection item associated with defect exists?

NO

YES

S24
Correct mounting parameter

S26
Select next inspection item

A

FIG. 9

```
                    ┌──────────────┐
                    │    Start     │
                    └──────────────┘
                           │
                           ▼
              ┌─────────────────────────┐
              │ Acquire measured value of │ ╱ S31
              │ defective inspection item │
              └─────────────────────────┘
                           │
                           ▼
              ┌─────────────────────────┐
              │  Acquire measured value in │ ╱ S32
              │   preceding process of   │
              │     target component     │
              └─────────────────────────┘
                           │
                           ▼
              ┌─────────────────────────┐
              │ Calculate correlation between │ ╱ S33
              │      inspection items      │
              └─────────────────────────┘
                           │
                           ▼
              ┌─────────────────────────┐
              │     Add combination to     │ ╱ S34
              │ inspection-item-associated table │
              └─────────────────────────┘
                           │
                           ▼
                    ┌──────────────┐
                    │     End      │
                    └──────────────┘
```

FIG. 10

Measured values in printing inspection and component inspection

- Solder volume
- Solder X-deviation
- Solder Y-deviation
- Component height
- Component X-deviation
- Component Y-deviation

Measured value of board determined to be defective by completion inspection.

Fillet height

Correlation between measured value distributions is obtained.

FIG. 11

Measured values in printing inspection
and component inspection

| Solder volume |
| Solder X-deviation |
| Solder Y-deviation |
| Component height |
| Component X-deviation |
| Component Y-deviation |

When
difference
exists,
inspection
items are
correlated
with each
other with
respect to
"fillet
height"

Measured value of board determined to
be defective by completion inspection

| Fillet height |

| Solder volume |
| Solder X-deviation |
| Solder Y-deviation |
| Component height |
| Component X-deviation |
| Component Y-deviation |

Measured value of board determined to
be nondefective by completion inspection

| Fillet height |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5560533 A
- JP 2006216589 A
- JP 2009116842 A

- JP 4020900 B
- JP 5017943 B